**Europäisches Patentamt**

**European Patent Office**

**Office européen des brevets**

(19)

(11) Veröffentlichungsnummer: **0 231 438**
**A2**

(12) # EUROPÄISCHE PATENTANMELDUNG

(21) Anmeldenummer: **86114765.0**

(22) Anmeldetag: **23.10.86**

(51) Int. Cl.⁴: **G06F 11/16**

(30) Priorität: **24.01.86 DE 3602112**

(43) Veröffentlichungstag der Anmeldung:
**12.08.87 Patentblatt 87/33**

(84) Benannte Vertragsstaaten:
**DE FR GB IT NL SE**

(71) Anmelder: **VDO Adolf Schindling AG**
**Gräfstrasse 103**
**D-6000 Frankfurt/Main(DE)**

(72) Erfinder: **Sinz, Wolfgang**
**Hofheimer Strasse 55a**
**D-6238 Hofheim a. T. 7(DE)**
Erfinder: **Kotulla, Günther**
**Rossertstrasse 7a**
**D-6231 Sulzbach/Ts.(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **System zur Speicherung von Informationen.**

(57) Bei einem System zur Speicherung von Informationen mit einem mehrere Speicherplätze umfassenden nichtflüchtigen Speicher wird jeweils eine Information nacheinander in zwei Speicherplätze eingeschrieben, von denen eine ungerade Anzahl in zyklischer Folge genutzt wird. Beim Auslesen nach einem Wiedereinschalten werden jeweils um einen Speicherplatz fortschreitend die Informationen von jeweils zwei benachbarten Speicherplätzen ausgelesen und auf Übereinstimmung geprüft. Aus der Folge von Übereinstimmungen und Abweichungen wird auf den Speicherplatz mit der gültigen Information geschlossen. Zur Überprüfung der Verbindung zwischen dem Prozessor und dem nichtflüchtigen Speicher wird von Zeit zu Zeit die Information mindestens eines weiteren Speicherplatzes gelesen und danach eine neue Information in den weiteren Speicherplatz eingeschrieben, die anschließend gelesen wird. Die neue Information und die vorherige werden miteinander verglichen. Bei Übereinstimmung wird eine Störung der Verbindung festgestellt.

FIG. 1

EP 0 231 438 A2

## System zur Speicherung von Informationen

Die Erfindung betrifft ein System zur Speicherung von Informationen mit einem mehrere Speicherplätze umfassenden nichtflüchtigen Speicher.

Bei datenverarbeitenden Systemen ist häufig eine Speicherung von Informationen auch uber Zeiträume erforderlich, bei welchen das betreffende System nicht mit Betriebsspannung versorgt wird. Dabei hat sich außer einer Speicherung mit Hilfe von gepufferten Schreib-Lese-Speichern eine Speicherung mit Hilfe sogenannter nichtflüchtiger Speicher bewährt. Die maximale Anzahl von Speicherungen pro Speicherplatz ist bei den derzeit erhältlichen nichtflüchtigen Speichern begrenzt. Es werden daher häufig nichtflüchtige Speicher verwendet, in welche die zu speichernden Informationen nacheinander in verschiedene Speicherplätze eingeschrieben werden. Dabei ist jedoch sicherzustellen, daß die zuletzt eingeschriebene Information nach dem Wiedereinschalten des Systems wiedergefunden wird. Schließlich ist sicher zustellen, daß im Falle des Ausbleibens der Betriebsspannung während eines Einschreibvorganges die letzte vollständig eingeschriebene Information beim Wiedereinschalten als gültige Information angesehen und weiterverarbeitet wird.

Aufgabe der vorliegenden Erfindung ist es, ein System zur Speicherung von Informationen anzugeben, welches die obigen Bedingungen erfüllt.

Das erfindungsgemäße System ist dadurch gekennzeichnet, daß jeweils eine Information nacheinander in zwei Speicherplätze eingeschrieben wird und daß von den Speicherplätzen eine ungerade Anzahl in zyklischer Folge genutzt wird. Das erfindungsgemäße System hat den Vorteil, daß die Speicherplätze eines nichtflüchtigen Speichers gleichmäßig "abgenutzt" werden, daß Voraussetzungen geschaffen sind, die zuletzt eingeschriebene Information wiederzufinden und daß eine letzte, gültige Information auch im Falle des plötzlichen Ausbleibens der Betriebsspannung abgespeichert ist und wiedergefunden wird.

Insbesondere bei elektronischen Anzeigesystemen, wie beispielsweise Anzeigesystemen in Kraftfahrzeugen, kann in vorteilhafter Weise von der Erfindung Gebrauch gemacht werden. So kann beispielsweise das Ergebnis einer elektronischen Füllstandsmessung eines Kraftfahrzeugtanks mit dem erfindungsgemäßen System gespeichert werden.

Gemäß einer Weiterbildung der Erfindung sind die Informationen Meßwerte, wobei jeweils ein Meßwert nach dem Einschreiben in den ersten Speicherplatz angezeigt und danach in den zweiten Speicherplatz eingeschrieben wird. Dadurch wird ermöglicht, daß der jeweils vor dem Abschalten angezeigte Meßwert beim erneuten Wiedereinschalten angezeigt wird.

Ein System zum Auslesen von Informationen aus einem mehrere Speicherplätze umfassenden nichtflüchtigen Speicher ist dadurch gekennzeichnet, daß nach einem Wiedereinschalten jeweils um einen Speicherplatz fortschreitend die Informationen von jeweils zwei benachbarten Speicherplätzen ausgelesen und auf Übereinstimmung geprüft werden und daß aus der Folge der Übereinstimmungen und Abweichungen auf den Speicherplatz mit der gültigen Information geschlossen wird. Mit Hilfe dieser Weiterbildung der Erfindung ist es ohne weitere Maßnahmen möglich, den jeweils zuletzt vor dem Ausbleiben der Betriebsspannung in den Speicher eingeschriebenen gültigen Meßwert zu erkennen und zur Anzeige zu bringen bzw. anderweitig zu verarbeiten.

Ferner ist ein System zum Speichern und/oder zum Auslesen von Informationen mit einem mehrere Speicherplätze umfassenden nichtflüchtigen Speicher und einem Prozessor, dadurch gekennzeichnet, daß zur Überprüfung der Verbindung zwischen dem Prozessor und dem nichtflüchtigen Speicher von Zeit zu Zeit die Information mindestens eines Speicherplatzes gelesen und danach eine neue Information in den Speicherplatz eingeschrieben wird, die anschließend gelesen wird, daß die neue Information und die vorherige miteinander verglichen werden und daß bei Übereinstimmung eine Störung der Verbindung festgestellt wird. Damit ist es mit geringstem Aufwand möglich, laufend die Verbindung zwischen dem Prozessor und dem nichtflüchtigen Speicher zu überprüfen, um insbe sondere zu verhindern, daß wichtige Daten, welche in dem nichtflüchtigen Speicher abgelegt werden sollen, unerkannt nicht auf diese Weise gesichert werden.

Gemäß einer Weiterbildung der Erfindung werden in weitere Speicherplätze des nichtflüchtigen Speichers zyklisch zu speichernde Informationen eingeschrieben und die Überprufung der Verbindung erfolgt einmal während eines jeden Zyklus.

Durch die in den weiteren Unteransprüchen aufgeführten Maßnahmen sind vorteilhafte Weiterbildungen und Verbesserungen der Erfindung möglich.

Die Erfindung läßt zahlreiche Ausführungsformen zu. Zwei davon sind schematisch in der Zeichnung an Hand mehrerer Figuren dargestellt und nachfolgend beschrieben. Es zeigt:

Fig. 1 ein Blockschaltbild eines erfindungsgemäßen Systems,

Fig. 2 schematisch die Belegung der Speicherplätze eines nichtflüchtigen Speichers in einem erfindungsgemäßen System während mehrerer Schreibzyklen,

Fig. 3 die Belegung der Speicherplätze nach einem Wiedereinschalten,

Fig. 4 ein Flußdiagramm eines ersten Teils und

Fig. 5 ein Flußdiagramm eines zweiten Teils des in dem Mikrocomputer abgespeicherten Programms.

Gleiche Teile sind in den Figuren mit gleichen Bezugszeichen versehen.

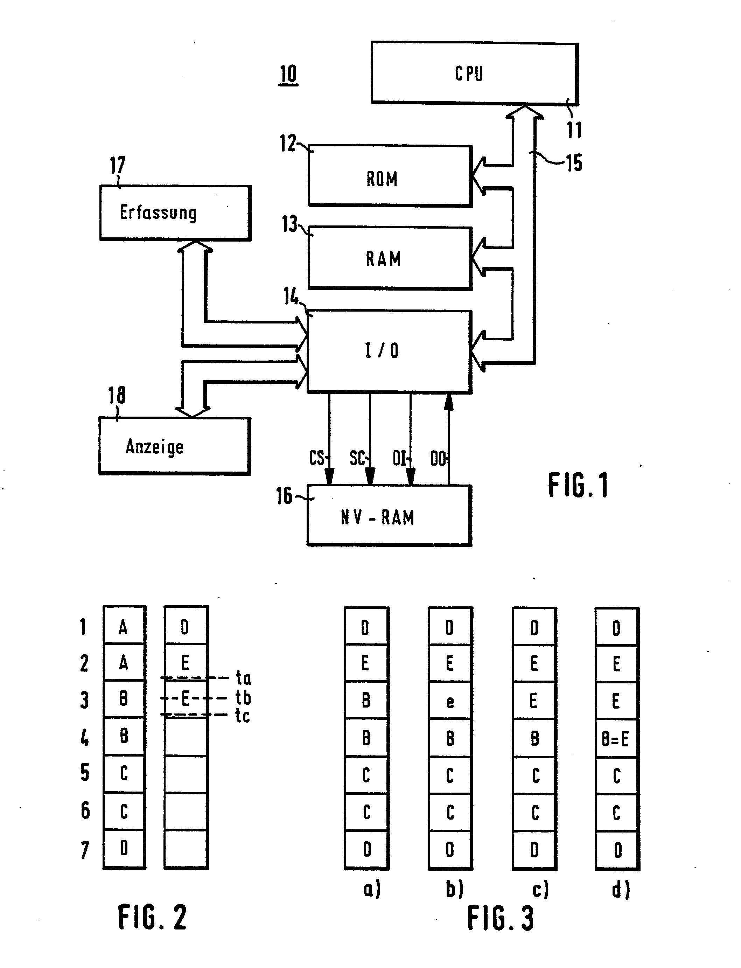

Bei dem in Fig. 1 als Blockschaltbild dargestellten System umfaßt ein Mikrocomputer 10, welcher beispielsweise als Ein-Chip-Computer ausgeführt ist, einen Prozessor 11, einen Nur-Lese-Speicher 12, einen Schreib-Lese-Speicher 13 und eine Ein/Ausgabe-Einheit 14, welche miteinander durch ein Bussystem 15 verbunden sind.

An den Mikrocomputer 10 ist ein nichtflüchtiger Speicher 16 angeschlossen. Die Verbindung erfolgt über die Leitungen DI (data input), DO (data output), CS (chip select) und SC (serial clock). An die Ein/Ausgabe-Einheit 14 sind ferner eine Erfassungseinheit 17 und eine Anzeigevorrichtung 18 angeschlossen.

Je nach Verwendungszweck des dargestellten Systems können die Erfassungseinheit 17, die Anzeige 18 und das im Nur-Lese-Speicher 12 gespeicherte Programm verschiedenartig ausgeführt sein. So kann beispielsweise das in Fig. 1 dargestellte System zur Füllstandsanzeige eines Kraftstofftanks eines Kraftfahrzeugs dienen, wobei die Erfassungseinheit 17 von einem geeigneten Sensor-System gebildet wird, während die Anzeigevorrichtung 18 beispielsweise eine Flüssigkristallanzeigevorrichtung ist. Der Mikrocomputer 10 wertet nun laufend die vom Sensor-System 17 erzeugten Signale aus und bringt diese zur Anzeige. Damit nach einer Betriebspause des Kraftfahrzeugs beim Wiedereinschalten sofort der gleiche Füllstand wie vor dem Abschalten angezeigt wird, ist ein nichtflüchtiger Speicher 16 vorgesehen. Die Erfindung gewährleistet nun, daß einerseits zur Erzielung einer genügend hohen Lebensdauer mehrere Speicherzellen in zyklischer Reihenfolge betrieben werden können, wobei beim Wiedereinschalten ohne weitere Maßnahmen der zuletzt gültige Meßwert erkannt wird. Andererseits ist gewährleistet, daß der zuletzt gültige Meßwert auch bei einem unkontrollierten Abschalten, beispielsweise während des Einschreibens eines Meßwertes, erkannt wird.

Die Funktion des erfindungsgemäßen Systems wird im folgenden an Hand der Figuren 2 und 3, welche schematisch die Belegung der Speicherplätze des nichtfluchtigen Speichers darstellen, erläutert. Während des Betriebs des Systems nach Fig. 1 werden die Speicherplätze 1 bis 7 des in Fig. 2 schematisch dargestellten nichtflüchtigen Speichers 16 nacheinander mit den Meßwerten beschrieben. Und zwar wird ein Meßwert, sobald er ermittelt ist, in den Speicher eingeschrieben, danach zur Anzeige gebracht und daraufhin in den folgenden Speicherplatz des Speichers eingeschrieben. Der Darstellung in Fig. 2 liegt demnach folgender Ablauf zugrunde:

In die Speicherplätze 1 und 2 wurde ein Meßwert A eingeschrieben und, sobald sich die zu messende Größe geändert hat, der neue Meßwert B in die Speicherplätze 3 und 4, dann ein Meßwert C in die Speicherplätze 5 und 6 und ein Meßwert D in den Speicherplatz 7 und -wegen der ungeraden Anzahl von Speicherplätzen -in den Speicherplatz 1. Der Meßwert E wird dann in die Speicherplätze 2 und 3 eingeschrie ben usw.

Die auf dem Markt erhältlichen nichtflüchtigen Speicher weisen im allgemeinen eine gerade Anzahl, vorzugsweise ein Vielfaches von acht, auf. Durch eine geeignete Programmierung kann jedoch bei der zyklischen Vertauschung ein Speicherplatz übersprungen werden.

Die Darstellung a), b) und c) in Fig. 3 zeigen die Inhalte der Speicherplätze 1 bis 7 des nichtflüchtigen Speichers nach dem Abschalten zu verschiedenen Zeitpunkten. Und zwar sind die Inhalte der Speicherplätze in Fig. 3a) dargestellt, nachdem das System nach Einschreiben der Information E in den Speicherplatz 2 abgeschaltet wurde (Zeitpunkt ta).

Fig. 3b) zeigt den Inhalt der Speicherplätze, nachdem das System während des Einschreibens in den Speicherplatz 3 abgeschaltet wurde - (Zeitpunkt tb), so daß beim zweiten Einschreiben der Information E lediglich eine verstummelte Information e in den Speicherplatz 3 eingeschrieben wurde. Die Darstellung nach Fig. 3c) setzt voraus, daß ein Abschalten des Systems nach dem zweiten Einlesen der Information E bei tc erfolgte.

Schließlich ist in Fig. 3d) noch ein Sonderfall dargestellt, der darin besteht, daß die Information bzw. der Meßwert E dem Meßwert B entspricht, so daß nach dem Abschalten während der mit ta bzw. tc bezeichneten Zeitpunkte drei gleiche Informationen in den Speicherzellen 2, 3 und 4 vorhanden sind.

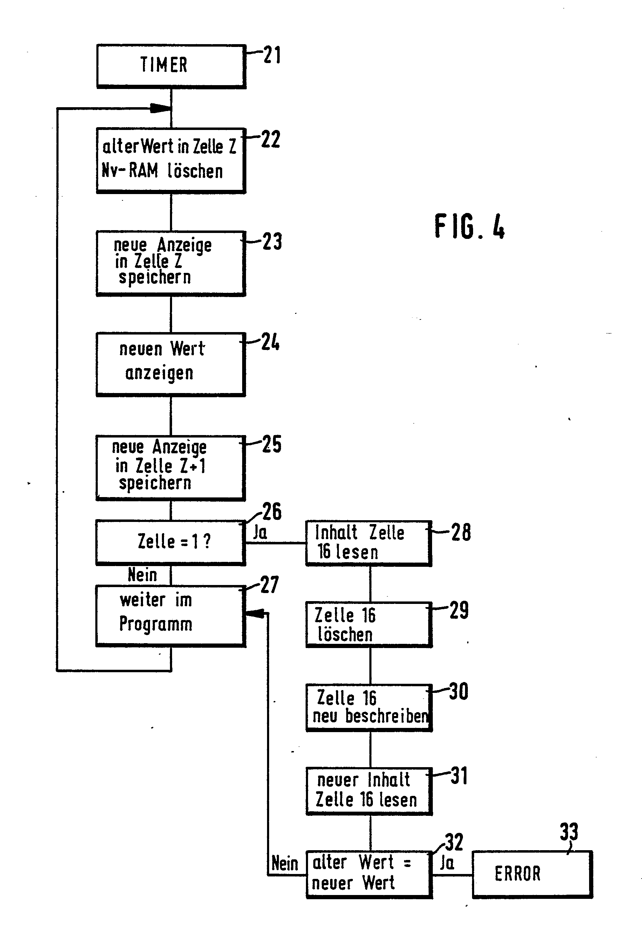

Das Flußdiagramm gemäß Fig. 4 zeigt das Einschreiben der Werte in den nichtflüchtigen Speicher 16 (Fig. 1) nach dem in Fig. 2 dargestellten Schema. Nach dem Festlegen der verschiedenen zeitlichen Abläufe bei 21 wird der alte Wert in dem Speicherplatz bzw. in der Zelle z gelöscht. Der neue Wert wird bei 23 in Zelle z gespeichert und bei 24 zur Anzeige (Fig. 1, Anzeigevorrichtung 18) gebracht. Danach wird der gleiche Wert bei 25 in die Zelle z + 1 eingeschrieben. Bei 26 wird geprüft, ob eine bestimmte Zelle, beispielsweise die Zelle 1, beschrieben wurde. Ist dieses nicht der Fall, so wird das Programm bei 27 fortgesetzt. Es wird unter anderem z um 2 erhöht. Die Verwendung eines nichtflüchtigen Speichers mit 16 Zellen bzw. Speicherplätzen vorausgesetzt, wird die Erhöhung des Adressenzählers beim z um jeweils 2, derart durchgeführt, daß die Zelle 16 dabei übersprungen wird. Auf die Zelle 15 folgt also die Zelle 1. Außerdem ist innerhalb des Programmteils 27 Vorsorge getroffen, daß das in Fig. 4 dargestellte Programm zum Einschreiben der Werte nur dann bei 22 fortgesetzt bzw. wiederholt wird, wenn ein neuer Meßwert vorliegt.

Wird bei 26 erkannt, daß die Zelle 1 beschrieben wurde, so wird das Programm bei 28 fortgesetzt. Der Inhalt der Zelle 16 wird gelesen und anschließend bei 29 gelöscht. Der Mikrocomputer 10 (Fig. 1) ermittelt dann für die Zelle 16 einen neuen Wert, der bei 30 in Zelle 16 eingeschrieben wird. Bei 31 wird der neue Inhalt aus der Zelle 16 wieder gelesen und bei 32 mit dem alten Inhalt verglichen. Stimmen beide Werte überein, kann darauf auf eine Unterbrechung der Verbindungen zwischen dem Mikrocomputer und dem nichtflüchtigen Speicher geschlossen werden. Bei 33 wird der Fehler angezeigt. Sind beide Werte verschieden, so wird das Programm bei 27 fortgesetzt.

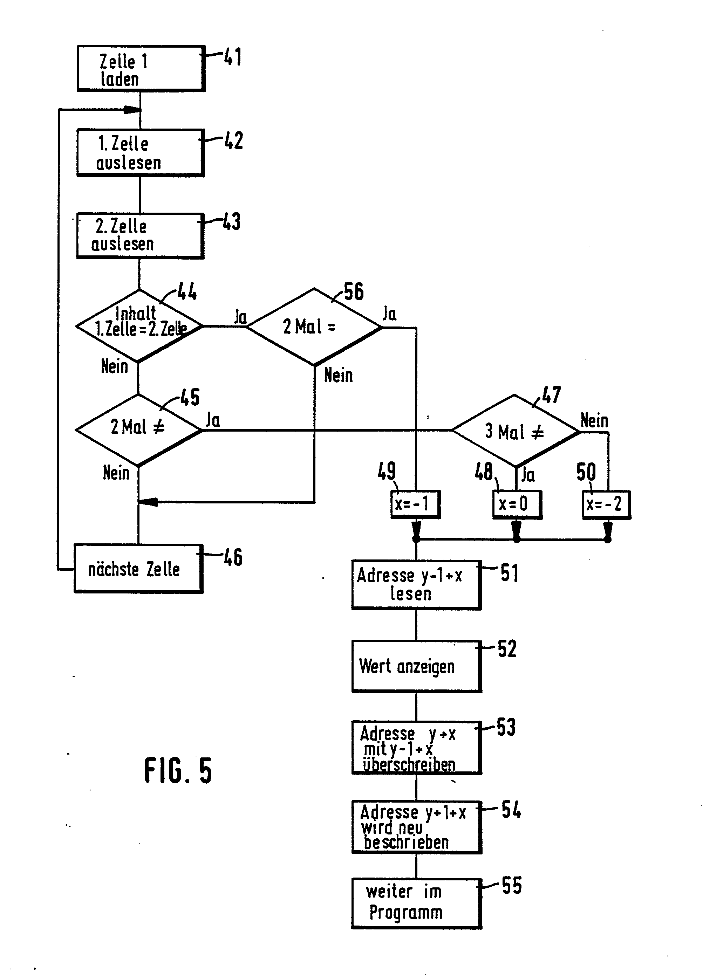

Fig. 5 zeigt einen Teil des im Mikrocomputer 10 gespeicherten Programms, mit welchem ein Meßwert, welcher zuletzt vor dem Abschalten in den nichtflüchtigen Speicher eingeschrieben wurde, ermittelt und ausgelesen wird. Bei 41 wird eine Anfangsadresse der zuerst zu überprüfenden Zelle, beispielsweise der Zelle 1, in den Arbeitsspeicher des Mikrocomputers geladen. Bei 42 wird der Inhalt dieser Zelle ausgelesen, worauf bei 43 der Inhalt der Zelle mit der darauffolgenden Adresse ausgelesen wird. Im Programmteil 44 werden beide Inhalte miteinander verglichen. Sind sie verschieden, wird das Programm bei der Verzweigung 45 fortgesetzt, mit deren Hilfe entschieden wird, ob die Inhalte zweier aufeinander folgender Zellen zweimal verschieden sind. Ist dies nicht der Fall, so kann daraus geschlossen werden, daß kein zuletzt vor dem Abschalten eingeschriebener Wert vorliegt. Bei 46 wird dann die Adresse für die nächste Zelle ermittelt und das Programm mit dem Auslesen dieser Zelle bei 42 fortgesetzt.

Ist jedoch der Inhalt von jeweils zwei benachbarten Zellen zweimal hintereinander verschieden, wird von der Verzweigung 45 ausgehend das Programm bei der Verzweigung 47 fortgesetzt. Hier wird darüber entschieden, ob auch ein drittes Mal zwischen benachbarten Zellen Unterschiede vorliegen. So wird beispielsweise bei dem in Fig. 3a) dargestellten Inhalt zwischen der Zelle 1 und der Zelle 2 ein Unterschied festgestellt, d. h. das Programm wird von der Verzweigung 44 zur Verzweigung 45 geleitet. Von der Zelle 2 zur Zelle 3 wird ebenfalls ein Unterschied festgestellt, so daß das Programm die Verzweigung 45 bei "ja" verläßt. Bei 47 wird dann festgestellt, daß nicht ein drittes Mal Ungleichheit vorliegt (die Zellen 3 und 4 haben jeweils den Inhalt B), worauf bei 48 der Wert x gleich 0 gesetzt wird. Bei 51 wird dann die Adresse derjenigen Zelle ermittelt, in welcher der zuletzt gültige Wert vor einem Abschalten bzw. einer anderen Unterbrechung der Betriebsspannung eingeschrieben wurde. Bei dem in Fig. 3a) dargestellten Beispiel ist dieses die Adresse der Zelle 2. Der aus der Zelle 2 ausgelesene Wert wird dann bei 52 angezeigt. In die darauffolgende Zelle wird der gleiche Wert E eingeschrieben, damit für den weiteren Betrieb die Folge von jeweils zweimaligem Einschreiben desgleichen Wertes erhalten bleibt. In die übernächste Zelle wird dann, wie im Zusammenhang mit Fig. 4 erläutert wurde, der nächste Meßwert eingeschrieben. Bei 55 ist der weitere Programmablauf angedeutet.

Bei der in Fig. 3b) dargestellten Speicherbelegung wird vorausgesetzt, daß der Einschreibvorgang zur Zeit tb unterbrochen wurde, so daß die Information E nur verstümmelt als Information e in die Zelle 3 eingeschrieben wurde. Bei der Überprüfung der Inhalte ergibt sich, daß eine Verschiedenheit der Inhalte dreimal hintereinander auftritt. Das Programm verläßt die Verzweigung 47 bei "ja", worauf bei 50 der Wert x gleich -2 gesetzt wird. Die Adresse mit dem zuletzt gültigen Wert, also die Adresse der Zelle 2 wird dann wiederum im Programmteil 51 ermittelt. Bei dem in Fig. 3c) dargestellten Fall wurde die Betriebsspannung nach dem zweiten Einschreiben des Wertes E abgeschaltet. Mit Hilfe des in Fig. 5 dargestellten Programmteils wird eine zweimalige Abwei chung festgestellt. Die Verzweigung 47 wird mit "nein" verlassen, der Wert x wird bei 48 gleich 0 gesetzt und die Adresse bei 51 ermittelt.

Der in Fig. 3d) dargestellte Fall ergibt sich, wenn die zu speichernde Meßgröße nach etwa einem Durchlauf der Speicherplätze den gleichen Wert annimmt. In diesem Fall sei angenommen, daß E gleich B sei. Nach dem Abschalten bei ta oder tc befindet sich in den Zellen 2, 3 und 4 der gleiche Inhalt. Dieses wird mit Hilfe der Verzweigung 56 erkannt, da hier zweimal aufeinander folgend die Inhalte zweier hintereinander liegenden Zellen gleich sind. Der Wert x wird dann bei 49 gleich -1 gesetzt und die Adresse 51, in diesem Fall zu Zelle 2, ermittelt.

**Ansprüche**

1. System zur Speicherung von Informationen mit einem mehrere Speicherplätze umfassenden nichtflüchtigen Speicher, dadurch gekennzeichnet, daß jeweils eine Information nacheinander in zwei Speicherplätze eingeschrieben wird und daß von den Speicherplätzen eine ungerade Anzahl in zyklischer Folge genutzt wird.

2. System nach Anspruch 1, dadurch gekennzeichnet, daß die Informationen Meßwerte sind und daß jeweils ein Meßwert nach dem Einschreiben in den ersten Speicherplatz angezeigt wird und danach in den zweiten Speicherplatz eingeschrieben wird.

3. System zum Auslesen von Informationen aus einem mehrere Speicherplätze umfassenden nichtflüchtigen Speicher, dadurch gekennzeichnet, daß nach einem Wiedereinschalten jeweils um einen Speicherplatz fortschreitend die Informationen von jeweils zwei benachbarten Speicherplätzen ausgelesen und auf Übereinstimmung geprüft werden und daß aus der Folge von Übereinstimmungen und Abweichungen auf den Speicherplatz mit der gültigen Information geschlossen wird.

4. System nach Anspruch 3, dadurch gekennzeichnet, daß die Adresse a des Speicherplatzes mit gültiger Information aus der Folge der Übereinstimmungen bzw. Abweichungen mit Hilfe der Gleichung $a = j - 1 + x$ ermittelt wird, wobei j die Adresse des jeweils zweitletzten abgefragten Speicherplatzes ist und x bei zweimaliger Abweichung und einmaliger Übereinstimmung gleich 0, bei dreimaliger Abweichung gleich -2 und bei zweimaliger Übereinstimmung gleich -1 ist, und daß bei anderen Folgen Speicherplätze mit jeweils um 1 erhöhten Adressen auf Übereinstimmung geprüft werden.

5. System nach Anspruch 3 oder 4, dadurch gekennzeichnet, daß die gültige Information in den folgenden Speicherplatz eingeschrieben wird.

6. System nach Anspruch 5, dadurch gekennzeichnet, daß die Information ein anzuzeigender Meßwert ist und vor dem Einschreiben in den folgenden Speicherplatz einer Anzeigevorrichtung zugeleitet wird.

7. System zum Speichern und/oder zum Auslesen von Informationen mit einem mehrere Speicherplätze umfassenden nichtflüchtigen Speicher und einem Prozessor, dadurch gekennzeichnet, daß zur Überprüfung der Verbindung zwischen dem Prozessor und dem nichtflüchtigen Speicher von Zeit zu Zeit die Information mindestens eines Speicherplatzes gelesen und danach eine neue Information in den Speicherplatz eingeschrieben wird, die anschließend gelesen wird, daß die neue Information und die vorherige miteinander verglichen werden und daß bei Übereinstimmung eine Störung der Verbindung festgestellt wird.

8. System nach Anspruch 7, dadurch gekennzeichnet, daß in weitere Speicherplätze des nichtflüchtigen Speichers zyklisch zu speichernde Informationen eingeschrieben werden und daß die Überprüfung der Verbindung einmal während eines jeden Zyklus erfolgt.

## FIG. 1

CPU

10

12 — ROM

13 — RAM

14 — I / O

17 — Erfassung

18 — Anzeige

11

15

CS  SC  DI  DO

16 — NV - RAM

## FIG. 2

| 1 | A | D |
| 2 | A | E | — ta |
| 3 | B | -E- | — tb |
| 4 | B |   | — tc |
| 5 | C |   |
| 6 | C |   |
| 7 | D |   |

## FIG. 3

| a) | b) | c) | d) |
|---|---|---|---|
| D | D | D | D |
| E | E | E | E |
| B | e | E | E |
| B | B | B | B=E |
| C | C | C | C |
| C | C | C | C |
| D | D | D | D |

## FIG. 4

```
        ┌──────────────┐
        │    TIMER     │──21
        └──────┬───────┘
               │
  ┌────────────┤
  │            ▼
  │   ┌──────────────────┐
  │   │alter Wert in Zelle Z│──22
  │   │ Nv-RAM löschen   │
  │   └────────┬─────────┘
  │            ▼
  │   ┌──────────────────┐
  │   │  neue Anzeige    │──23
  │   │  in Zelle Z      │
  │   │  speichern       │
  │   └────────┬─────────┘
  │            ▼
  │   ┌──────────────────┐
  │   │   neuen Wert     │──24
  │   │   anzeigen       │
  │   └────────┬─────────┘
  │            ▼
  │   ┌──────────────────┐
  │   │  neue Anzeige    │──25
  │   │  in Zelle Z+1    │
  │   │  speichern       │
  │   └────────┬─────────┘
  │            ▼          26
  │   ┌──────────────┐ Ja    ┌──────────────┐
  │   │  Zelle = 1 ? │───────│ Inhalt Zelle │──28
  │   └──────┬───────┘       │  16 lesen    │
  │      Nein                └──────┬───────┘
  │          ▼          27          ▼
  │   ┌──────────────┐       ┌──────────────┐
  │   │  weiter im   │──── ◄─│  Zelle 16    │──29
  │   │  Programm    │       │  löschen     │
  │   └──────────────┘       └──────┬───────┘
  └──────                           ▼
                            ┌──────────────┐
                            │  Zelle 16    │──30
                            │ neu beschreiben│
                            └──────┬───────┘
                                   ▼
                            ┌──────────────┐
                            │ neuer Inhalt │──31
                            │ Zelle 16 lesen│
                            └──────┬───────┘
                                   ▼        32            33
                      Nein ┌──────────────┐ Ja  ┌──────────────┐
                           │ alter Wert = │─────│    ERROR     │
                           │ neuer Wert   │     └──────────────┘
                           └──────────────┘
```

FIG. 5